# EUROPEAN PATENT SPECIFICATION

(11) **EP 1 942 559 B1**
(45) Date of publication and mention of the grant of the patent: **03.10.2012**
(21) Application number: 06796962.6
(22) Date of filing: 29.08.2006
(51) Int. Cl.: H05K 3/30, H01R 12/70, H01R 12/72

(54) **ELECTRIC CONNECTOR**
ELEKTRISCHER VERBINDER
CONNECTEUR ELECTRIQUE

(30) Priority: 27.10.2005 JP 2005313202
(43) Date of publication of application: 09.07.2008
(73) Proprietor: Tyco Electronics Japan G.K., Takatsu-ku Kawasaki-shi Kagawa 213-8535 (JP)
(72) Inventor: YAMAGAMI, Hidehisa, Kawasaki-shi, Kanagawa 2138535 (JP); MITO, Yusuke, Kawasaki-shi, Kanagawa 2138535 (JP)
(74) Representative: Johnstone, Douglas Ian
(86) International application number: PCT/JP2006/316985
(87) International publication number: WO 2007/049395

(56) References cited:
- EP-A2- 0 810 697
- WO-A2-02/082584
- JP-A- 11 307 201
- JP-A- 2000 164 273
- US-A- 4 655 517
- US-A- 5 370 540

## Description

### TECHNICAL FIELD

The present invention relates to an electrical connector comprising a tine plate into which the fillet parts of the solder wetting up the tine parts of the contacts do not encroach when these tine parts are connected by soldering to a circuit board via this tine plate.

### BACKGROUND ART

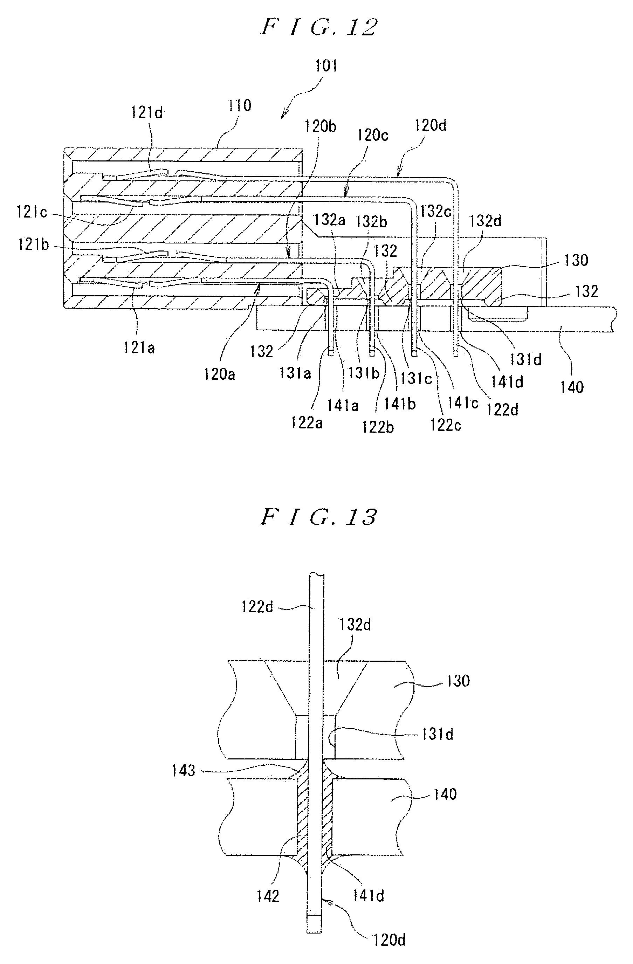

The electrical connector shown in FIGS. 12 and 13 (see Japanese Patent Application Kokai No. H7-302653), for example, has been known in the past as an electrical connector comprising a tine plate having a construction which is such that solder sufficiently rises in through-holes in a circuit board when the tine parts of contacts are soldered to the circuit board via this tine plate. FIG. 12 is a sectional view of a conventional example of an electrical connector. FIG. 13 is an explanatory diagram showing a state in which the tine part of a contact in the fourth row is connected by soldering to a through-hole in the circuit board. In FIG. 12, the electrical connector 101 comprises an insulating housing 110 that extends in the direction of length (the direction perpendicular to the plane of the page in FIG. 12), contacts 120a, 120b, 120c, and 120d that are secured to the housing 110 in four rows in the vertical direction, and a tine plate 130.

Furthermore, the contacts 120a, 120b, 120c, and 120d in four rows respectively comprise contact parts 121 a, 121 b, 121 c, and 121d that are fastened to the housing and that make contact with mating contacts (not shown in the figures), and tine parts 122a, 122b, 122c, and 122d. The individual tine parts 122a, 122b, 122c, and 122d are formed by respectively extending from the contact parts 121a, 121b, 121c, and 121d toward the rear of the housing 110 (the direction opposite of the mating surface, i.e., rightward in FIG. 12) and then being bent downward at a right angle. The tine parts 122a of the contacts 120a in the first row from the bottom are designed such that the portions of these tine parts 122a that are bent at a right angle are positioned on the innermost side (leftmost side in FIG. 12 and on the side close to the housing 110), and that these tine parts 122a are respectively inserted into first-row through-holes 141 a that are formed in a circuit board 140 and that are located on the innermost side (leftmost side in FIG. 12 and on the side close to the housing 110), and are respectively connected by soldering to a conductor layer on the inner surfaces of the through-holes 141a. Moreover, the tine parts 122b of the contacts 120b in the second row from the bottom are designed such that the portions of these tine parts 122b that are bent at a right angle are located in the second position from the inside, and that these tine parts 122b are respectively inserted into second-row through-holes 141b that are formed in the circuit board 140 and that are located in the second position from the inside, and are respectively connected by soldering to a conductor layer on the inner surfaces of the through-holes 141b. In addition, the tine parts 122c of the contacts 120c in the third row from the bottom are designed such that the portions of these tine parts 122c that are bent at a right angle are located in the third position from the inside, and that these tine parts 122c are respectively inserted into third-row through-holes 141c that are formed in the circuit board 140 and that are located in the third position from the inside, and are respectively connected by soldering to a conductor layer on the inner surfaces of the through-holes 141c. Likewise, the tine parts 122d of the contacts 120d in the fourth and uppermost row are designed such that the portions of these tine parts 122d that are bent at a right angle are positioned on the outermost side, and that these tine parts 122d are respectively inserted into fourth-row through-holes 141d that are formed in the circuit board 140 and that are located on the outermost side, and are respectively connected by soldering to a conductor layer on the inner surfaces of the through-holes 141d.

Furthermore, the tine plate 130 is constructed from a substantially rectangular plate that extends in the direction of length of the housing 110, and has through-holes 131a, 131b, 131c, and 131d in four rows formed in positions corresponding to the respective through-holes 141a,141b, 141c, and 141d in the circuit board 140. Moreover, tapered parts 132a, 132b, 132c, and 132d for easily guiding the respective tine parts 122a, 122b, 122c, and 122d into the individual through-holes 131 a, 131b, 131c, and 131d are provided in the respective through-holes 131a, 131b, 131c, and 131d on the side of the insertion of the tine parts. In addition, once the respective tine parts 122a, 122b, 122c, and 122d are inserted into the individual through-holes 131a, 131b, 131c, and 131d in the tine plate 130, these tine parts 122a, 122b, 122c, and 122d can be respectively aligned with the individual through-holes 141a, 141b, 141c, and 141d in the circuit board 140.

Furthermore, projections 132 that extend in the direction of length are respectively provided on the undersurface of the tine plate 130 on the inside of the through-holes 131a in the first row from the inside (on the side close to the housing 110), between the through-holes 131b in the second row from the inside and the through-holes 131c in the third row from the inside, and on the outside of the through-holes 131d in the fourth row on the outermost side. As a result, when the electrical connector 101 is mounted on the circuit board 140 by respectively inserting the tine parts 122a, 122b, 122c, and 122d into the through-holes 131a, 131b, 131c, and 131d in the tine plate 130, and respectively inserting the tine parts 122a, 122b, 122c, and 122d protruding from the undersurface of the tine plate 130 into the through-holes 141a, 141b, 141c, and 141d in the circuit board, the projections 132 contact the upper surface of the circuit board 140. This creates a step difference between the upper surface of the circuit board 140 and the undersurface of the tine plate 130, and the respective through-holes 131a, 131b, 131c, and 131d are positioned in the portion of the lower step. Consequently, a gap is created between the tine plate 130 and the circuit board 140 in the portions where these through-holes 131a, 131b, 131c, and 131d are present in the tine plate 130.

Then, when the respective tine parts 122a, 122b, 122c, and 122d are connected by soldering to the individual through-holes 141a, 141b, 141c, and 141 d in the circuit board 140 in the subsequent soldering process, if the reverse side of the circuit board 140 that is mounted on the electrical connector 101 is exposed to a molten solder jet, a capillary action occurs in each of the through-holes 141a, 141b, 141c, and 141d because of the existence of appropriate space inside the individual through-holes 141a, 141b, 141c, and 141d between the inner walls and the respective tine parts 122a, 122b, 122c, and 122d. Accordingly, as is shown in FIG. 13, the solder 142 that is in a molten state moves up inside each of the through-holes 141a, 141b, 141c, and 141d in the circuit board 140 to the upper surface of the circuit board 140 due to the capillary action. The molten solder 142 further wets up each of the tine parts 122a, 122b, 122c, and 122d from the upper surface of the circuit board 140 due to the surface tension, and the tip end of this molten solder in each through-hole forms a fillet part 143 that reaches near the tine plate 130.

WO 02/082584, on which the preamble of claim 1 is based, discloses an electrical connector comprising a housing. Conductive terminals in the form of a matrix are secured to the housing and respectively have tine parts which extend towards the outside of the housing and are then bent downward. An aligner plate extends in a direction parallel to the housing and has positioning holes into which the respective tine parts of the conductive terminals are inserted and which is arranged to align the tine parts with holes formed in a circuit board. Rows of elongated movable portions are located in an upper level of the aligner plate, and the movable portions extend across the width of the plate and away from the housing. There is a recess beneath each said elongated movable portion and the elongated portions may have a single row of the positioning holes.

EP 0810697 discloses a base plate connector comprising a connector housing. Terminal pins in the form of a matrix are secured to the housing and respectively have tine parts which extend towards the outside of the housing and are then bent downward. An alignment plate extends in a direction parallel to the housing and has position fixing holes formed in two rows into which the respective tine parts of the terminal pins are inserted and which is arranged to align the tine parts with connecting holes formed in a circuit base plate. Each position fixing hole has a recessed part formed in an underside of the alignment plate.

US 5370540 discloses a circuit board connector comprising a connector block. Connecter pins are secured to the connector block and have tine parts which extend through holes in the connector block towards the outside of the connector block and into holes formed in a circuit board. Each hole in the connector block has a recessed part formed in an underside of the connector block.

### DISCLOSURE OF THE INVENTION

However, the following problem has been encountered in a conventional electrical connector 101 such as that disclosed in Japanese Patent Application Kokai No. H7-302653. Specifically, the tine plate 130 is designed such that a gap is created between the undersurface of this tine plate 130 and the upper surface of the circuit board 140 by making the plate thickness smaller (thinner) in all portions having the through-holes 131a, 131b, 131c, and 131d; therefore, the surface area of the portions of this tine plate 130 where the gap is created from the circuit board 140 occupies most of the total surface area, creating a problem in that the mechanical strength is insufficient. In particular, when an electrical connector 101 comprising a tine plate 130 is mounted on a circuit board used for an automobile engine control unit, this electrical connector 101 is subjected to a large temperature difference and vibration during use, so that the mechanical strength of the tine plate 130 becomes a problem.
Accordingly, the present invention was devised in light of this problem; it is an object of the present invention to provide an electrical connector comprising a tine plate in which the mechanical strength of this tine plate is essentially not lowered, and the fillet parts of the solder wetting up the tine parts can be prevented from encroaching on this tine plate.

In order to solve the problem described above, the electrical connector of Claim 1 is an electrical connector comprising a housing, contacts in the form of a matrix that are secured to the housing and that respectively have tine parts which extend toward the outside of the housing and are then bent downward, and a tine plate that extends in a direction substantially parallel to the housing and that has through-holes formed in a plurality of rows and columns in the form of a matrix into which the respective tine parts of the contacts in the form of a matrix are inserted and which is arranged to align the tine parts with through-holes formed in a circuit board, wherein a recessed part is formed in the undersurface of the tine plate and encompasses a region containing some through-holes among the through-holes in the form of a matrix, characterized in that the some through-holes in the recessed part comprise a plurality of through-holes in a direction substantially parallel to the housing and in two rows adjacent to the housing.

In the electrical connector of Claim 1, because a recessed part is formed in the undersurface of the tine plate only in a region encompassing some through-holes among the through-holes in the form of a matrix, the distance between the circuit board and the undersurface of the tine plate can be made greater than in the past in the region in which the recessed part is formed and which encompasses these through-holes, so that the fillet parts of the solder wetting up the tine parts when the tine parts are connected by soldering to the circuit board can be reliably prevented from encroaching on the tine plate in the portion where the recessed part is formed. Furthermore, because the recessed part is formed in the undersurface of the tine plate only in a region encompassing some through-holes among the through-holes in the form of a matrix, there is no lowering of the mechanical strength of the tine plate.

Moreover, the through-holes in the tine plate are formed in a plurality of rows and columns, and the recessed part is formed in a region encompassing through-holes present in a portion near the housing. In cases where the thermal expansion coefficients of the tine plate and circuit board are different, a difference is generated between the amounts of expansion and contraction of the tine plate and the amounts of expansion and contraction of the circuit board by the variations in the temperature, and stress is repeatedly generated in the parts soldered to the circuit board via the tine parts, so that cracking may occur in these soldered parts. Meanwhile, the tine parts that are shorter in length among the tine parts of the contacts in the plurality of rows and columns are respectively inserted into the through-holes that are present in a portion near the housing. Therefore, the portion having these through-holes is a portion where the tine plate is more predisposed to restraint than the other portions. That is, because the shorter tine parts are less likely to undergo deformation than the longer tine parts, the tine plate is more easily restrained in the portion having the through-holes into which these shorter tine parts are inserted than in the other portions. Accordingly, in cases where the circuit board and tine plate thermally expand due to the temperature variations, the expansion and contraction of the portion of the tine plate which has the through-holes near the housing is more easily restrained, and the difference from the amounts of expansion and contraction of the circuit board is increased, so that an excessive force is applied to the tine parts from the tine plate, resulting in a problem in that the stress on the soldered parts is increased. Thus, because the recessed part is formed in a region encompassing through-holes that are present in a portion near the housing, the restraint of the expansion and contraction of the portion of the tine plate that has the through-holes near the housing can be alleviated in cases where the tine plate thermally expands due to the temperature variations; as a result, stress on the soldered parts can be reduced.

The recessed part is formed in a region encompassing a plurality of through-holes present within a region encompassing the through-holes in two rows adjacent to the housing. Accordingly, in cases where the tine plate thermally expands due to the temperature variations, it is possible to alleviate the restraint of the amounts of expansion and contraction of the portion having a plurality of through-holes present within a region encompassing the through-holes in two rows adjacent to the housing. As a result, stress on the soldered parts can be reduced.

The recessed parts may be formed in regions encompassing through-holes that are present in both end portions of the tine plate in the direction of length. As was described above, in cases where the thermal expansion coefficients of the tine plate and circuit board are different, a difference is created between the amounts of expansion and contraction of the tine plate and the amounts of expansion and contraction of the circuit board by the temperature variations, and stress is repeatedly generated in the parts soldered to the circuit board via the tine parts, so that cracking may occur in these soldered parts. Here, in cases where thermal expansion takes place due to the temperature variations, the amounts of expansion and contraction in the direction of length of the tine plate are accumulated in both end portions of the tine plate in the direction of length, so that the amounts of expansion and contraction in these portions are large. Accordingly, in cases where the circuit board and tine plate thermally expand due to the temperature variations, the amounts of expansion and contraction of portions having through-holes present in both end portions of the tine plate in the direction of length become excessively large, so that the difference from the amounts of expansion and contraction of the circuit board is increased; therefore, an excessive force is applied to the tine parts from the tine plate, resulting in a problem in that the stress on the soldered parts is increased. Thus, by forming the recessed parts in regions encompassing through-holes that are present in both end portions of the tine plate in the direction of length, it is possible to reduce the amounts of expansion and contraction in portions having through-holes that are present in both end portions of the tine plate in the direction of length in cases where the tine plate undergoes thermal expansion due to the temperature variations; as a result, stress on the soldered parts can be reduced.

The recessed part may be formed in a region encompassing either one or a plurality of through-holes present within a region that is 20% of the length of the tine plate in the direction of length from an end of the tine plate in the direction of length. Accordingly, in cases where the tine plate thermally expands due to the temperature variations, it is possible to reduce the amounts of expansion and contraction in a portion having one or a plurality of through-holes present within a region that is at least 20% of the length of the tine plate in the direction of length from an end of the tine plate in the direction of length; as a result, stress on the soldered parts can be reduced.
The recessed part may be formed in a region encompassing either one or a plurality of through-holes present within a region encompassing the through-holes in three columns adjacent to an end of the tine plate in the direction of length. Accordingly, in cases where the tine plate thermally expands due to the temperature variations, it is possible to reduce the amounts of expansion and contraction in a portion having one or a plurality of through-holes present within a region encompassing the through-holes in at least three columns adjacent to an end of the tine plate in the direction of length; as a result, stress on the soldered parts can be reduced.

### BRIEF DESCRIPTION OF THE DRAWINGS

FIG. 1 is a perspective view showing the electrical connector of the present invention and a mating connector prior to mating;
FIG. 2 is a plan view of the electrical connector shown in FIG. 1;
FIG. 3 is a front view of the electrical connector shown in FIG. 1;
FIG. 4 is a right side view of the electrical connector shown in FIG. 1;
FIG. 5 is a left side view of the electrical connector shown in FIG. 1;
FIG. 6 is a bottom view of the electrical connector shown in FIG. 1;
FIG. 7 is a back view of the electrical connector shown in FIG. 1;
FIG. 8 is a perspective view in a state in which the electrical connector shown in FIG. 1 is mounted on a circuit board;
FIG. 9 is a plan view of the electrical connector and circuit board shown in FIG. 8;
FIG. 10 is a sectional view along line 10-10 in FIG. 9;
FIG. 11 is an enlarged view of the area indicated by arrow A in FIG. 10;
FIG. 12 is a sectional view of a conventional example of an electrical connector; and
FIG. 13 is an explanatory diagram showing a state in which the tine part of a contact in the fourth row is connected by soldering to a through-hole in the circuit board.

### Explanation of Symbols

- 1:: Electrical connector
- 10:: Housing
- 20a-20f:: First contacts
- 20a₂-20f₂:: Tine parts
- 21a-21d:: Second contacts
- 21a₂-21d₂:: Tine parts
- 22a-22d:: Third contacts
- 22a₂-22d₂:: Tine parts
- 30:: Tine plate
- 30a-30f:: First through-holes
- 31a-31d:: Second through-holes
- 32a-32d:: Third through-holes
- 33:: First recessed parts
- 34:: Second recessed part
- 35:: Third recessed part
- 40:: Circuit board
- 40a-40f:: First through-holes

### BEST MODE FOR CARRYING OUT THE INVENTION

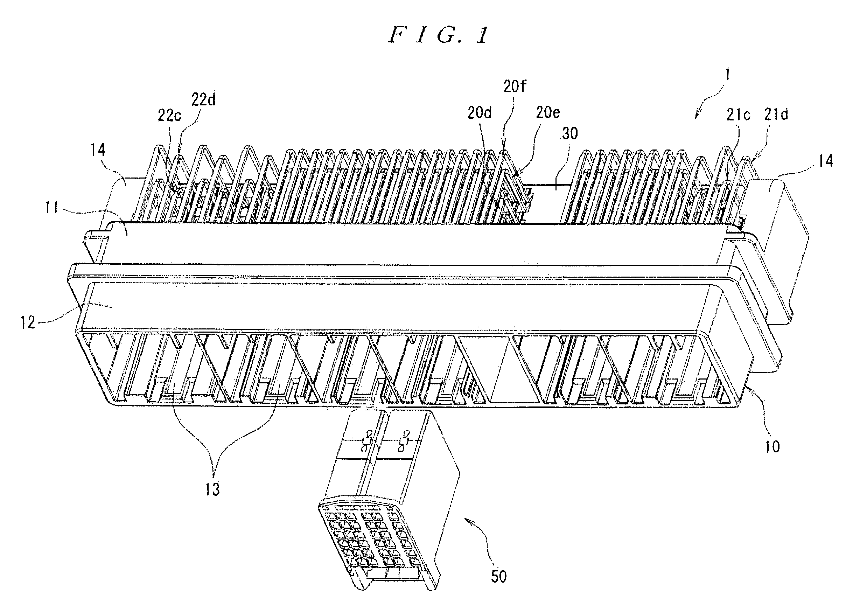

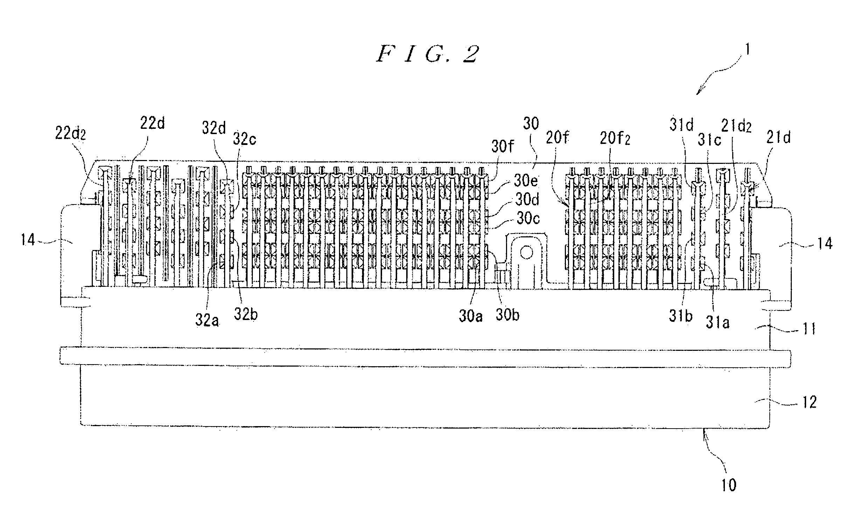

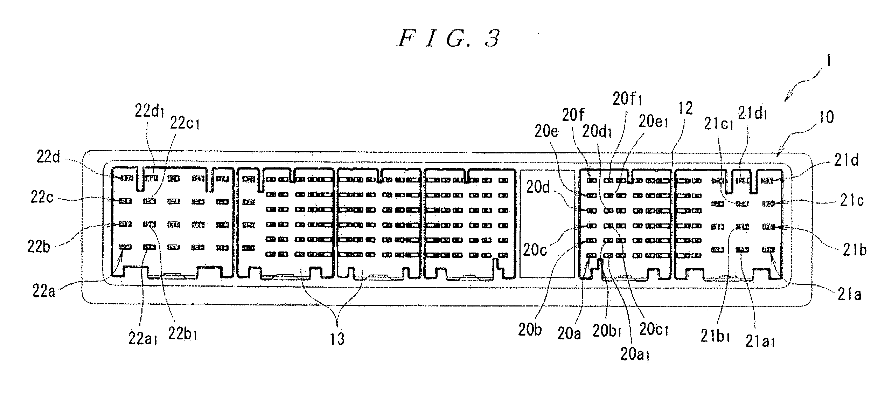

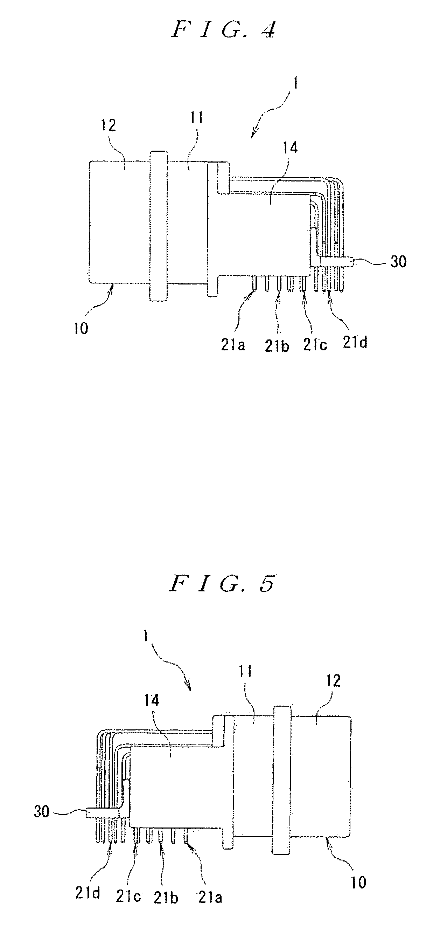

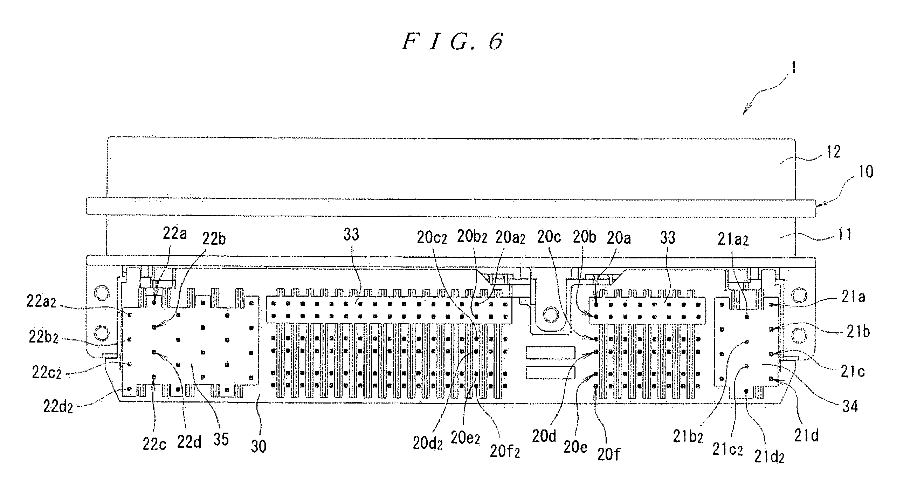

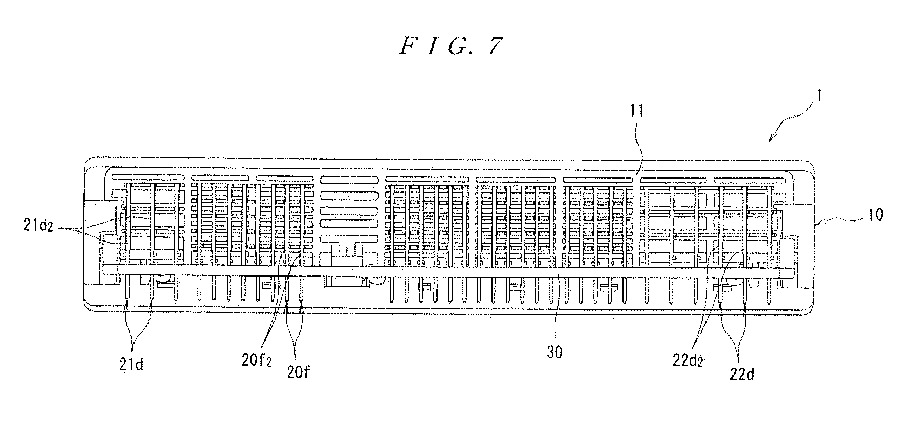

Next, an embodiment of the present invention will be described with reference to the figures. FIG. 1 is a perspective view showing the electrical connector of the present invention and a mating connector prior to mating. FIG. 2 is a plan view of the electrical connector shown in FIG. 1. FIG. 3 is a front view of the electrical connector shown in FIG. 1. FIG. 4 is a right side view of the electrical connector shown in FIG. 1. FIG. 5 is a left side view of the electrical connector shown in FIG. 1. FIG. 6 is a bottom view of the electrical connector shown in FIG. 1. FIG. 7 is a back view of the electrical connector shown in FIG. 1.

As is shown in FIG. 1, the electrical connector 1 is designed such that a plurality of mating connectors 50 (only one mating connector 50 is shown in FIG. 1) mate with this electrical connector 1.
Here, as is shown in FIGS. 1 through 7, the electrical connector 1 comprises a housing 10, a tine plate 30, and first contacts 20a, 20b, 20c, 20d, 20e, and 20f in a plurality of rows and columns (6 rows and 25 columns in the present embodiment), second contacts 21 a, 2 1 b, 21c, and 21d in a plurality of rows and columns (4 rows and 3 columns in the present embodiment), and third contacts 22a, 22b, 22c, and 22d in a plurality of rows and columns (4 rows and 6 columns in the present embodiment) which are secured to the housing 10. With regard to the first contacts, the first contacts 20a in the bottommost row in FIG. 3 are the first-row first contacts, the first contacts 20b in the second row from the bottom are the second-row first contacts, the first contacts 20c in the third row from the bottom are the third-row first contacts, the first contacts 20d in the fourth row from the bottom are the fourth-row first contacts, the first contacts 20e in the fifth row from the bottom are the fifth-row first contacts, and the first contacts 20f in the topmost row are the sixth-row first contacts. Furthermore, with regard to the second contacts, the second contacts 21a in the bottommost row in FIG. 3 are the first-row second contacts, the second contacts 21b in the second row from the bottom are the second-row second contacts, the second contacts 21c in the third row from the bottom are the third-row second contacts, and the second contacts 21d in the topmost row are the fourth-row second contacts. Moreover, with regard to the third contacts, the third contacts 22a in the bottommost row in FIG. 3 are the first-row third contacts, the third contacts 22b in the second row from the bottom are the second-row third contacts, the third contacts 22c in the third row from the bottom are the third-row third contacts, and the third contacts 22d in the topmost row are the fourth-row third contacts.

Furthermore, the housing 10 is formed by molding an insulating resin, and comprises a substantially rectangular housing base part 11 that extends in the direction of length (left-right direction in FIGS. 2 and 3), and a substantially rectangular mating part 12 that protrudes forward (toward the bottom in FIG. 2) from the housing base part 11 and that extends in the direction of length. A plurality of mating connector mating recessed parts 13 (six recessed parts in the present embodiment) with which mating connectors 50 mate are formed in the mating part 12 of the housing 10. Moreover, a pair of locking parts 14 for locking the tine plate 30 are provided on either end of the housing base part 11 in the direction of length.

In addition, as is shown in FIGS. 1 through 3, the first contacts 20a through 20f are attached substantially to the central portion of the housing 10 in the direction of length along the direction of length of the housing 10, the second contacts 21a through 21d are provided in the right end portion of the housing 10 in the direction of length along the direction of length of the housing 10, and the third contacts 22a through 22d are provided in the left end portion of the housing 10 in the direction of length along the direction of length of the housing 10.

Here, the respective first contacts 20a through 20f in the first through sixth rows are fastened to the housing base part 11, and comprise contact parts 20a₁, 20b₁, 20c₁, 20d₁, 20e₁, and 20f₁ (see FIG. 3) that extend into four mating connector mating recessed parts 13 located substantially in the central portion of the housing in the direction of length. These individual first contacts 20a through 20f in the first through sixth rows also respectively comprise tine parts 20a₂, 20b₂, 20c₂, 20d₂, 20e₂, and 20f₂ (see FIG. 6) that respectively extend from the contact parts 20a₁ through 20f₁ toward the rear of the housing base part 11 (toward the outside of the housing 10 and upward in FIG. 2). The respective tine parts 20a₂ through 20f₂ are formed by being bent downward at a right angle after extending toward the rear of the housing base part 11. Each of the first contacts 20a through 20f in the first through sixth rows is constructed from a pin member that is formed by stamping and forming a metal plate.

Furthermore, the respective second contacts 21a through 21d in the first through fourth rows are fastened to the housing base part 11, and comprise contact parts 21a₁, 21b₁, 21c₁, and 21d₁ (see FIG. 3) that extend into the mating connector mating recessed part 13 located at the right end portion of the housing in the direction of length. These individual second contacts 2 1a through 2 1d in the first through fourth rows also respectively comprise tine parts 21a₂, 21b₂, 21c₂, and 21d₂ (see FIG. 6) that respectively extend from the contact parts 21a₁ through 21d₁ toward the rear of the housing base part 11 (toward the outside of the housing 10 and upward in FIG. 2). The respective tine parts 21a₂ through 21d₂ are formed by being bent downward at a right angle after extending toward the rear of the housing base part 11. As is shown in FIG. 6, the right-angled bent portions of the tine parts 21a₂ through 21d₂ of the second contacts 21a through 21d in the second column from the right side of the housing 10 in the direction of length respectively extend to positions that are shifted rearward with respect to the right-angled bent portions of the tine parts 21a₂ through 21d₂ of the second contacts 21a through 21d in the first and third columns, which are adjacent to the second column on both sides thereof. As a result, the right-angled bent portions of the tine parts 21a₂ through 21d₂ of the second contacts 21 a through 21 d in the respective rows are arranged in a staggered fashion along the direction of length of the housing 10. Furthermore, each of the second contacts 21 a through 21 d in the first through fourth rows is constructed from a pin member that is formed by stamping and forming a metal plate.

Moreover, the respective third contacts 22a through 22d in the first through fourth rows are fastened to the housing base part 11, and comprise contact parts 22a₁, 22b₁, 22c₁, and 22d₁ (see FIG. 3) that extend into the mating connector mating recessed parts 13 located at the left end portion of the housing in the direction of length. These individual third contacts 22a through 22d in the first through fourth rows also respectively comprise tine parts 22a₂, 22b₂, 22c₂, and 22d₂ (see FIG. 6) that respectively extend from the contact parts 22a₁ through 22d₁ toward the rear of the housing base part 11 (toward the outside of the housing 10 and upward in FIG. 2). The respective tine parts 22a₂ through 22d₂ are formed by being bent downward at a right angle after extending toward the rear of the housing base part 11. As is shown in FIG. 6, the right-angled bent portions of the tine parts 22a₂ through 22d₂ of the third contacts 22a through 22d in the first, third, and fifth columns from the left side of the housing 10 in the direction of length respectively extend to positions that are shifted rearward with respect to the right-angled bent portions of the tine parts 22a₂ through 22d₂ of the third contacts 22a through 22d in the second, fourth, and sixth columns, which are adjacent to the first, third, and fifth columns on both sides thereof. As a result, the right-angled bent portions of the tine parts 22a₂ through 22d₂ of the third contacts 22a through 22d in the respective rows are arranged in a staggered fashion along the direction of length of the housing 10. In addition, each of the third contacts 22a through 22d in the first through fourth rows is constructed from a pin member that is formed by stamping and forming a metal plate.

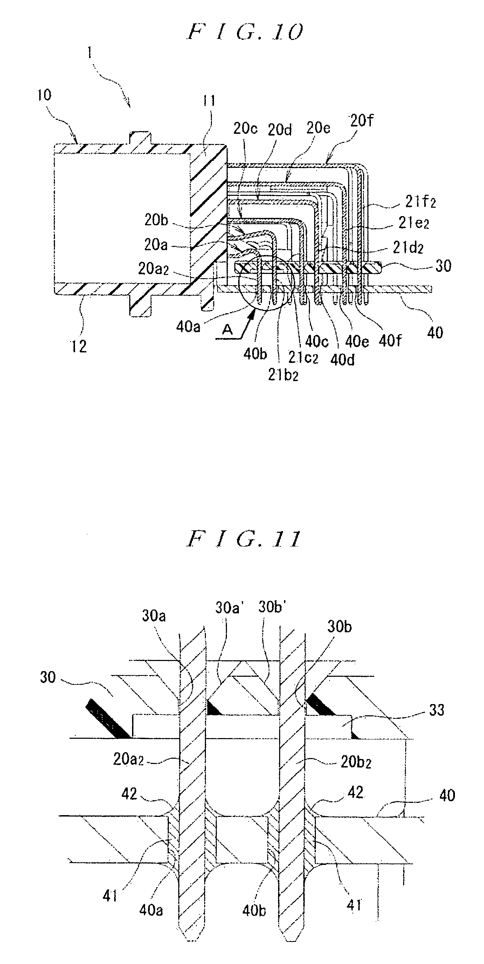

In addition, as is shown in FIGS. 2, 6, and 7, the tine plate 30 is constructed from a substantially rectangular plate-form body that extends in the direction of length (left-right direction in FIG. 2), and is formed by molding an insulating resin. As is shown in FIGS. 2 and 6, first through-holes 30a, 30b, 30c, 30d, 30e, and 30f in a plurality of rows and columns (6 rows and 25 columns in the present embodiment) into which the right-angled bent portions of the respective tine parts 20a₂ through 20f₂ of the first contacts 20a through 20f in the plurality of rows and columns are respectively inserted are formed in the tine plate 30. These first through-holes 30a through 30f are formed substantially in the central portion of the tine plate 30 in the direction of length along the direction of length of the tine plate 30 corresponding to the right-angled bent portions of the tine parts 20a₂ through 20f₂ of the first contacts 20a through 20f. The first through-holes 30a through 30f in the respective rows are arranged in a staggered fashion along the direction of length of the housing 10. Furthermore, the first through-holes 30a through 30f are formed in positions corresponding to the first through-holes 40a through 40f (see FIG. 10) in a circuit board 40. With regard to the first through-holes, the first through-holes 30a in the row closest to the housing 10 in FIG. 2 are the first-row first through-holes, the first through-holes 30b in the second closest row are the second-row first through-holes, the first through-holes 30c in the third closest row are the third-row first through-holes, the first through-holes 30d in the fourth closest row are the fourth-row first through-holes, the first through-holes 30e in the fifth closest row are the fifth-row first through-holes, and the first through-holes 30f in the row farthest to the housing 10 are the sixth-row first through-holes. Furthermore, tapered parts (only the tapered parts 30a' and 30b' that are respectively provided in the first through-holes 30a and 30b in the first and second rows are shown in FIG. 11) for easily guiding the respective tine parts 20a₂ through 20f₂ into the individual through-holes 30a through 30f are provided in the respective first through-holes 30a through 30f on the side of the insertion of the tine parts.

Furthermore, second through-holes 31a, 31b, 31c, and 31d in a plurality of rows and columns (4 rows and 3 columns in the present embodiment) into which the right-angled bent portions of the respective tine parts 21a₂ through 21d₂ of the second contacts 21a through 21d in the plurality of rows and columns are respectively inserted are formed in the tine plate 30. These second through-holes 31 a through 31 d are formed in the right end portion of the tine plate 30 in the direction of length along the direction of length of the tine plate 30 corresponding to the right-angled bent portions of the tine parts 21a₂ through 21d₂ of the second contacts 21a through 21d. The second through-holes 31 a through 31 d in the respective rows are arranged in a staggered fashion along the direction of length of the housing 10. Moreover, the second through-holes 31a through 31d are formed in positions corresponding to second through-holes (not shown in the figures) in the circuit board 40. With regard to the second through-holes, the second through-holes 31a in the row closest to the housing 10 in FIG. 2 are the first-row second through-holes, the second through-holes 31b in the second closest row are the second-row second through-holes, the second through-holes 31c in the third closest row are the third-row second through-holes, and the second through-holes 31d in the row farthest to the housing 10 are the fourth-row second through-holes. Furthermore, tapered parts (not shown in the figures) for easily guiding the respective tine parts 21a₂ through 21d₂ into the individual through-holes 31a through 31d are provided in the respective second through-holes 31a through 31d on the side of the insertion of the tine parts.

Moreover, third through-holes 32a, 32b, 32c, and 32d in a plurality of rows and columns (4 rows and 6 columns in the present embodiment) into which the perpendicular portions of the respective tine parts 22a₂ through 22d₂ of the third contacts 22a through 22d in the plurality of rows and columns are respectively inserted are formed in the tine plate 30. These third through-holes 32a through 32d are formed in the left portion of the tine plate 30 in the direction of length along the direction of length of the tine plate 30 corresponding to the right-angled bent portions of the tine parts 22a₂ through 22d₂ of the third contacts 22a through 22d. The third through-holes 32a through 32d in the respective rows are arranged in a staggered fashion along the direction of length of the housing 10. Furthermore, the third through-holes 32a through 32d are formed in positions corresponding to third through-holes (not shown in the figures) in the circuit board 40. With regard to the third through-holes, the third through-holes 32a in the row closest to the housing 10 in FIG. 2 are the first-row third through-holes, the third through-holes 32b in the second closest row are the second-row third through-holes, the third through-holes 32c in the third closest row are the third-row third through-holes, and the third through-holes 32d in the row farthest to the housing 10 are the fourth-row third through-holes. In addition, tapered parts (not shown in the figures) for easily guiding the respective tine parts 22a₂ through 22d₂ into the individual through-holes 32a through 32d are provided in the respective third through-holes 32a through 32d on the side of the insertion of the tine parts.

Furthermore, the right-angled bent portions of the tine parts 20a₂ through 20f₂ of the first contacts 20a through 20f are respectively inserted into the first through-holes 30a through 30f in the tine plate 30. The respective first through-holes 30a through 30f have the function of aligning the inserted right-angled bent portions with the first through-holes formed in the circuit board 40 (described later). Similarly, furthermore, the right-angled bent portions of the tine parts 21a₂ through 21d₂ of the second contacts 21 a through 21 d are respectively inserted into the second through-holes 31a through 31d in the tine plate 30. The respective second through-holes 31a through 31d have the function of aligning the inserted right-angled bent portions with the second through-holes formed in the circuit board 40. Moreover, the right-angled bent portions of the tine parts 22a₂ through 22d₂ of the third contacts 22a through 22d are respectively inserted into the third through-holes 32a through 32d in the tine plate 30. The respective third through-holes 32a through 32d have the function of aligning the inserted right-angled bent portions with the third through-holes formed in the circuit board 40. Furthermore, the tine plate 30 is designed to be locked with the locking parts 14 provided on the housing 10 and to restrict the downward movement after the right-angled bent portions of the tine parts 20a₂ through 20f₂ of the first contacts 20a through 20f are respectively inserted into the first through-holes 30a through 30f, the right-angled bent portions of the tine parts 21a₂ through 21d₂ of the second contacts 21a through 21d are respectively inserted into the second through-holes 31a through 31d, and the right-angled bent portions of the tine parts 22a₂ through 22d₂ of the third contacts 22a through 22d are respectively inserted into the third through-holes 32a through 32d.

Moreover, as is shown in FIGS. 2 and 6, first recessed parts 33 are formed in the undersurface of the tine plate 30 within regions encompassing all of the first through-holes 30a and 30b that are present within regions encompassing the first through-holes 30a and 30b in the first and second rows that are adjacent to the housing 10. The cross-sectional shape of each first recessed part 33 is rectangular as shown in FIG. 11 (described later). The depth of the first recessed parts 33 is approximately 1 mm in the present embodiment. Furthermore, the thickness of the tine plate 30 is approximately 2 mm.

Similarly, furthermore, as is shown in FIGS. 2 and 6, a second recessed part 34 is formed in the undersurface of the tine plate 30 in a region encompassing all of the second through-holes 31a through 31d that are present within a region encompassing the second through-holes 31a through 31d in the three columns adjacent to the right end of the tine plate 30 in the direction of length. The cross-sectional shape of the second recessed part 34 is similar to the shape of the first recessed parts 33, and the depth of the second recessed part 34 is also approximately 1 mm.

Likewise, as is shown in FIGS. 2 and 6, a third recessed part 35 is formed in the undersurface of the tine plate 30 in a region encompassing all of the third through-holes 32a through 32d that are present within a region which is 20% of the length of the tine plate 30 in the direction of length from the left end of the tine plate 30 in the direction of length. The cross-sectional shape of the third recessed part 35 is similar to the shape of the first recessed parts 33, and the depth of the third recessed part 35 is also approximately 1 mm.

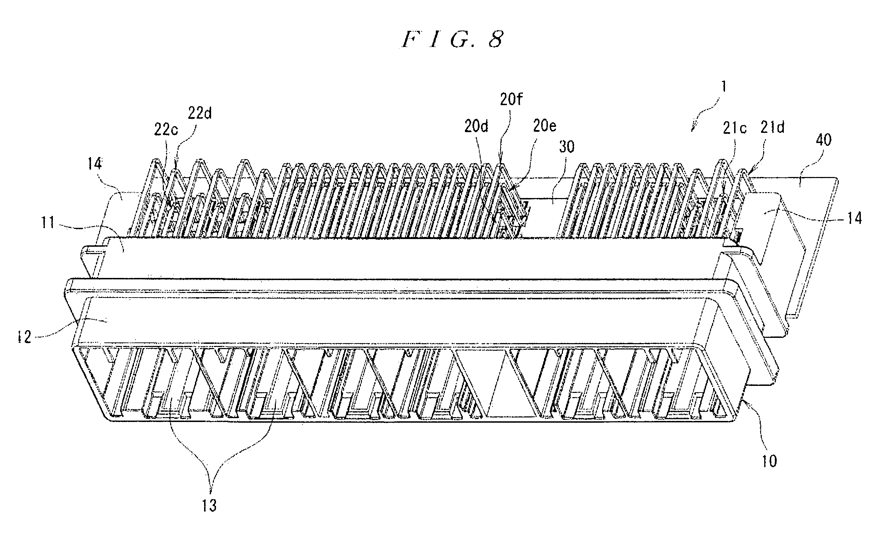

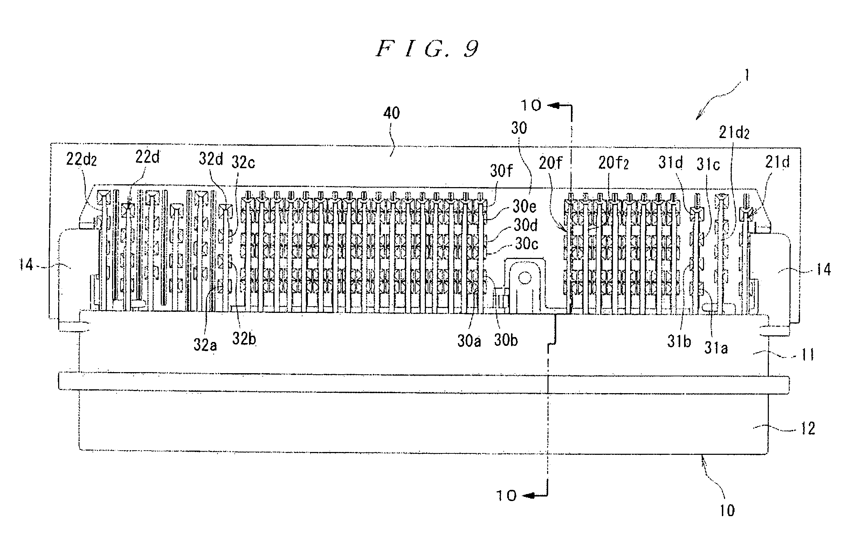

Next, a method for mounting the electrical connector 1 on the circuit board 40 will be described with reference to FIGS. 8 through 11. FIG. 8 is a perspective view in a state in which the electrical connector shown in FIG. 1 is mounted on the circuit board. FIG. 9 is a plan view of the electrical connector and circuit board shown in FIG. 8. FIG. 10 is a sectional view along line 10-10 in FIG. 9. FIG. 11 is an enlarged view of the area indicated by arrow A in FIG. 10.

First, prior to the mounting of the electrical connector 1 on the circuit board 40, the right-angled bent portions of the tine parts 20a₂ through 20f₂ of the first contacts 20a through 20f are respectively inserted into the first through-holes 30a through 30f in the tine plate 30, the right-angled bent portions of the tine parts 21a₂ through 21d₂ of the second contacts 21a through 21 d are respectively inserted into the second through-ho les 31a through 31d, and the right-angled bent portions of the tine parts 22a₂ through 22d₂ of the third contacts 22a through 22d are respectively inserted into the third through-holes 32a through 32d. Afterward, the tine plate 30 is locked with the locking parts 14 provided on the housing 10.

Then, as is shown in FIGS. 8, 10, and 11, the right-angled bent portions of the tine parts 20a₂ through 20f₂ of the first contacts 20a through 20f are respectively inserted into the first through-holes 40a, 40b, 40c, 40d, 40e, and 40f that are formed in the circuit board 40 at the same time, the right-angled bent portions of the tine parts 21a₂ through 21d₂ of the second contacts 21a through 21d are respectively inserted into the second through-holes (not shown in the figures) formed in the circuit board 40 at the same time, and the right-angled bent portions of the tine parts 22a₂ through 22d₂ of the third contacts 22a through 22d are respectively inserted into the third through-holes (not shown in the figures) formed in the circuit board at the same time. As a result, the electrical connector 1 is carried on one end portion of the circuit board 40 as shown in FIG. 10. In this state, the undersurface of the tine plate 30 and the upper surface of the circuit board 40 are separated by a specified distance as shown in FIGS. 10 and 11. This specified distance is preferably greater than the so-called wet-up height (height of fillet parts 42), which is the level to which molten solder 41 crawls up and reaches the tine surfaces from the upper surface of the circuit board 40 due to surface tension.

In the insertion of the right-angled bent portions of the tine parts 20a₂ through 20f₂, 21a₂ through 21 d₂, and 22a₂ through 22d₂, the individual first through-holes 30a through 30f in the tine plate 30 respectively align the right-angled bent portions of the tine parts 20a₂ through 20f₂ with the first through-holes 40a through 40f, the individual second through-holes 31a through 31d respectively align the right-angled bent portions of the tine parts 21 a2 through 21 d₂ with the second through-holes, and the individual third through-holes 32a through 32d respectively align the right-angled bent portions of the tine parts 22a₂ through 22d₂ with the third through-holes. Therefore, the insertion of the respective right-angled bent portions is performed smoothly.

Then, as is shown in FIG. 11 (only the solder connection in the first through-holes is shown in FIG. 11), the soldering of the right-angled bent portions of the tine parts 20a₂ through 20f₂, the right-angled bent portions of the tine parts 21a₂ through 21 d₂, and the right-angled bent portions of the tine parts 22a₂ through 22d₂ is respectively performed in the first through-holes 40a through 40f, second through-holes, and third through-holes. As a result, the first contacts 20a through 20f, second contacts 21 a through 21d, and third contacts 22a through 22d of the electrical connector 1 are electrically connected to the circuit board 40.

When soldering is performed as described above, a capillary action occurs in each of the first through-holes 40a through 40f, second through-holes, and third through-holes. As a result, as is shown in FIG. 11, the solder 41 that is in a molten state moves up to the upper surface of the circuit board 40 inside the respective first through-holes 40a through 40f, second through-holes, and third through-holes in the circuit board 40 due to the capillary action. Furthermore, the molten solder 41 wets up the right-angled bent portions of the respective tine parts 20a₂ through 20f₂, 21a₂ through 21 d₂, and 22a₂ through 22d₂ from the upper surface of the circuit board 40 due to the surface tension, and the tip end of the molten solder 41 in each through-hole forms a fillet part 42 that reaches the vicinity of the halfway position between the tine plate 30 and circuit board 40. Thus, because the tine plate 30 and the circuit board 40 are separated by a specified distance, i.e., a distance greater than the so-called wet-up height (height of the fillet parts 42), which is the level to which the molten solder 41 crawls up and reaches the tine surfaces from the upper surface of the circuit board 40 due to the surface tension, the fillet parts 42 of the solder 41 do not encroach on the tine plate 30.

Here, as is shown in FIGS. 2 , 6, and 11, the first recessed parts 33 are formed in the undersurface of the tine plate 30 in regions encompassing all of the first through-holes 30a and 30b that are present within regions encompassing the first through-holes 30a and 30b in the first and second rows that are adjacent to the housing 10. Therefore, the distance between the circuit board 40 and the undersurface of the tine plate 30 can be made greater than in the past in the regions in which these first recessed parts 33 are formed and which encompass the first through-holes 30a and 30b, so that the fillet parts 42 of the solder 41 wetting up the tine parts 20a₂ and 20b₂ when the tine parts 20a₂ and 20b₂ are connected by soldering to the circuit board 40 can be reliably prevented from encroaching on the tine plate 30 in the portions where the first recessed parts 33 are formed.

Moreover, as is shown in FIGS. 2 and 6, the second recessed part 34 is formed in the undersurface of the tine plate 30 in a region encompassing all of the second through-holes 31a through 3 1d that are present within a region encompassing the second through-holes 31a through 31d in the three columns adjacent to the right end of the tine plate 30 in the direction of length. Therefore, the distance between the circuit board 40 and the undersurface of the tine plate 30 can be made greater than in the past in the region in which this second recessed part 34 is formed and which encompasses the second through-holes 31 a through 31d, so that the fillet parts 42 of the solder 41 that wets up the tine parts 21a₂ through 21d₂ when the tine parts 21a₂ through 21d₂ are connected by soldering to the circuit board 40 can be reliably prevented from encroaching on the tine plate 30 in the portion where the second recessed part 34 is formed.

In addition, as is shown in FIGS. 2 and 6, the third recessed part 35 is formed in the undersurface of the tine plate 30 in a region encompassing all of the third through-holes 32a through 32d that are present within a region which is 20% of the length of the tine plate 30 in the direction of length from the left end of the tine plate 30 in the direction of length. Therefore, the distance between the circuit board 40 and the undersurface of the tine plate 30 can be made greater than in the past in the region in which this third recessed part 35 is formed and which encompasses the third through-holes 32a through 32d, so that the fillet parts 42 of the solder 41 that wets up the tine parts 22a₂ through 22d₂ when the tine parts 22a₂ through 22d₂ are connected by soldering to the circuit board 40 can be reliably prevented from encroaching on the tine plate 30 in the portion where the third recessed part 35 is formed.

Furthermore, the first recessed parts 33, second recessed part 34, and third recessed part 35 formed in the undersurface of the tine plate 30 are formed in the undersurface of the tine plate 30 in regions encompassing some of the through-holes among the first through-holes 30a through 30f, second through-holes 31a through 31d, and third through-holes 32a through 32d in the plurality of rows and columns. Accordingly, there is no drop in the mechanical strength of the tine plate 30.

Here, in cases where the thermal expansion coefficients of the tine plate 30 and circuit board 40 are different, a difference is generated between the amounts of expansion and contraction of the tine plate 30 and the amounts of expansion and contraction of the circuit board 40 by the variations in the temperature, and stress is repeatedly generated in the parts soldered to the circuit board 40 via the tine parts 20a₂ through 20f₂, 21a₂ through 21d₂, and 22a₂ through 22d₂, so that cracking may occur in these soldered parts. Meanwhile, the tine parts 20a₂ and 20b₂ that are shorter in length among the tine parts 20a₂ through 20f₂ of the first contacts 20a through 20f in the plurality of rows and columns are respectively inserted into the first through-holes 30a and 30b that are present within the regions encompassing the first through-holes 30a and 30b in the two rows adjacent to the housing 10. Therefore, these portions where the first through-holes 30a and 30b are present are portions where the tine plate 30 is more predisposed to restraint than the other portions. That is, because the shorter tine parts 20a₂ and 20b₂ are less likely to undergo deformation than the longer tine parts, the tine plate 30 is more predisposed to restraint in the portions having the first through-holes 30a and 30b into which these shorter tine parts 20a₂ and 20b₂ are inserted than in the other portions. Accordingly, in cases where the circuit board 40 and tine plate 30 thermally expand due to the temperature variations, the expansion and contraction of the portions of the tine plate 30 which have the first through-holes 30a and 30b that are present within the regions encompassing the first through-holes 30a and 30b in the two rows adjacent to the housing 10 are more easily restrained, and the difference from the amounts of expansion and contraction of the circuit board 40 is increased, so that an excessive force is applied to the tine parts 20a₂ and 20b₂ from the tine plate 30, resulting in a problem in that the stress on the soldered parts is increased. Thus, because the first recessed parts 33 are formed in regions encompassing all of the first through-holes 30a and 30b that are present within regions encompassing the first through-holes 30a and 30b in the two rows adjacent to the housing 10, the restraint of the expansion and contraction of these portions having the first through-holes 30a and 30b can be alleviated in cases where the tine plate 30 thermally expands due to the temperature variations; as a result, stress on the soldered parts can be reduced.

Furthermore, the third recessed part 35 is formed in a region encompassing all of the third through-holes 32a through 32d that are present within a region which is 20% of the length of the tine plate 30 in the direction of length from the left end of the tine plate 30 in the direction of length. Moreover, the second recessed part 34 is formed in a region encompassing all of the second through-holes 31a through 31d that are present within a region encompassing the second through-holes 31a through 31d in the three columns adjacent to the right end of the tine plate 30 in the direction of length. In cases where the thermal expansion coefficients of the tine plate 30 and circuit board 40 are different as described above, a difference is generated between the amounts of expansion and contraction of the tine plate 30 and the amounts of expansion and contraction of the circuit board 40 by the variations in the temperature, and stress is repeatedly generated in the parts soldered to the circuit board 40 via the tine parts 20a₂ through 20f₂, 21a₂ through 21d₂, and 22a₂ through 22d₂, so that cracking may occur in these soldered parts. Here, in cases where thermal expansion takes place due to the temperature variations, the amounts of expansion and contraction in the direction of length of the tine plate 30 are accumulated within the region that is 20% of the length of the tine plate 30 in the direction of length from the left end of the tine plate 30 in the direction of length and within the region encompassing the second through-holes 31a through 31d in the three columns adjacent to the right end of the tine plate 30 in the direction of length, so that these amounts of expansion and contraction are large. Accordingly, in cases where the circuit board 40 and tine plate 30 thermally expand due to the temperature variations, the amounts of expansion and contraction become too large in the portion having the third through-holes 32a through 32d that are present within the region which is 20% of the length of the tine plate 30 in the direction of length from the left end of the tine plate 30 in the direction of length and in the portion having the second through-holes 31a through 31d that are present within a region encompassing the second through-holes 31a through 31d in the three columns adjacent to the right end of the tine plate 30 in the direction of length, so that the difference from the amounts of expansion and contraction of the circuit board 40 become large. As a result, an excessive force is applied to the tine parts 21a₂ through 21d₂ and 22a₂ through 22d₂, creating the problem of increasing the stress on the soldered parts. Accordingly, by forming the third recessed part 35 in the region encompassing all of the third through-holes 32a through 32d that are present within a region which is 20% of the length of the tine plate 30 in the direction of length from the left end of the tine plate 30 in the direction of length, and by forming the second recessed part 34 in the region encompassing all of the second through-holes 31a through 31d that are present within a region encompassing the second through-holes 31a through 31d in the three columns adjacent to the right end of the tine plate 30 in the direction of length, it is possible to reduce the amounts of expansion and contraction of the portions having these third through-holes 32a through 32d and second through-holes 31a through 31d in cases where the tine plate 30 thermally expands due to the temperature variations; as a result, the stress on the soldered parts can be reduced.

An embodiment of the present invention has been described above. However, the present invention is not limited to this embodiment, and various alterations and modifications can be made.
For example, the arrangement of the through-holes formed in the tine plate 30 is not limited to a plurality of rows and columns, and may also be in a single row and a plurality of columns or in a plurality of rows and a single column.
Furthermore, the recessed parts formed in the undersurface of the tine plate 30 are not limited to the first recessed parts 33 formed in regions encompassing all of the first through-holes 30a and 30b that are present within regions encompassing the first through-holes 30a and 30b in the first and second rows adjacent to the housing 10, the second recessed part 34 formed in a region encompassing all of the second through-holes 31a through 31d that are present within a region encompassing the second through-holes 31a through 31d in the three columns adjacent to the right end of the tine plate 30 in the direction of length, and the third recessed part 35 formed in a region encompassing all of the third through-holes 32a through 32d that are present within a region which is 20% of the length of the tine plate 30 in the direction of length from the left end of the tine plate 30 in the direction of length. It is sufficient if these recessed parts are formed in the undersurface of the tine plate 30 in regions encompassing some through-holes among the first through-holes 30a through 30f, second through-holes 31a through 31d, and third through-holes 32a through 32d in a plurality of rows and columns. In this case, the distance between the circuit board and the undersurface of the tine plate 30 can be made greater than in the past in regions encompassing the through-holes where the recessed parts are formed, so that the fillet parts 42 of the solder 41 wetting up the tine parts when the tine parts 20a₂ through 20f₂, 21a₂ through 21d₂, and 22a₂ through 22d₂ are connected by soldering to the circuit board 40 can be reliably prevented from encroaching on the tine plate 30 in the portions where the recessed parts are formed. Moreover, because the recessed parts are formed in the undersurface of the tine plate 30 in regions encompassing some through-holes among the first through-holes 30a through 30f, second through-holes 31a through 31d, and third through-holes 32a through 32d in a plurality of rows and columns, there is no drop in the mechanical strength of the tine plate 30.

In addition, the recessed parts formed in the undersurface of the tine plate 30 are not limited to the first recessed parts 33, second recessed part 34, and third recessed part 35; it would also be possible to form a recessed part in a region encompassing first through-holes, second through-holes, or third through-holes that are present in a portion near the housing 10. In this case, it is possible to alleviate the restraint on the expansion and contraction of the portion of the tine plate 30 that has the first through-holes, second through-holes, or third through-holes that are present near the housing 10 in cases where the tine plate 30 thermally expands due to the temperature variations; as a result, the stress on the soldered parts can be reduced.

Furthermore, the formation of the first recessed parts 33 is not limited to regions encompassing all of the first through-holes 30a and 30b that are present within regions encompassing the first through-holes 30a and 30b in the first and second rows adjacent to the housing 10; it would also be possible to form a first recessed part 33 in a region encompassing either one or a plurality of these first through-holes 30a and 30b. In this case, it is possible to alleviate the restraint on the expansion and contraction of the portion having either one or a plurality of the first through-holes 30a and 30b present within regions encompassing the first through-holes 30a and 30b in the two rows adjacent to the housing 10 in cases where the tine plate 30 thermally expands due to the temperature variations; as a result, the stress on the soldered parts can be reduced.

Moreover, the recessed parts formed in the undersurface of the tine plate 30 are not limited to the first recessed parts 33, second recessed part 34, and third recessed part 35, and may also be formed in regions encompassing the second through-ho les 31a through 3 1d and third through-holes 32a through 32d that are present in either end portion of the tine plate 30 in the direction of length. In this case, it is possible to reduce the amounts of expansion and contraction of the portions having the second through-holes 31a through 31d and third through-holes 32a through 32d that are present in either end portion of the tine plate 30 in the direction of length in cases where the tine plate 30 thermally expands due to the temperature variations; as a result, the stress on the soldered parts can be reduced.

In addition, the formation of the third recessed part 35 is not limited to a region encompassing all of the third through-holes 32a through 32d that are present within a region which is 20% of the length of the tine plate 30 in the direction of length from the left end of the tine plate 30 in the direction of length; the third recessed part 35 may also be formed in a region encompassing either one or a plurality of the third through-holes 32a through 32d. In this case, it is possible reduce the amounts of expansion and contraction of the portion having one or a plurality of the third through-holes 32a through 32d present within a region which is 20% of the length of the tine plate 30 in the direction of length from the left end of the tine plate 30 in the direction of length in cases where the tine plate 30 thermally expands due to the temperature variations; as a result, the stress on the soldered parts can be reduced.

Furthermore, the formation of the second recessed part 34 is not limited to a region encompassing all of the second through-holes 31a through 31d that are present within a region encompassing the second through-holes 31a through 31d in the three columns adjacent to the right end of the tine plate 30 in the direction of length; the second recessed part 34 may also be formed in a region encompassing either one or a plurality of the second through-holes 31 a through 31 d. In this case, it is possible to reduce the amounts of expansion and contraction of the portion having one or a plurality of the second through-holes 31a through 31d present within a region encompassing the second through-holes 31a through 31d in the three columns adjacent to the right end the tine plate 30 in the direction of length in cases where the tine plate 30 thermally expands due to the temperature variations; as a result, the stress on the soldered parts can be reduced.

## Claims

1. An electrical connector (1) comprising a housing (10), contacts (20a ... 20f) in the form of a matrix that are secured to the housing (10) and that respectively have tine parts (20a₂... 20f₂) which extend toward the outside of the housing (10) and are then bent downward, and a tine plate (30) that extends in a direction substantially parallel to the housing (10) and that has through-holes (30a ... 30f) formed in a plurality of rows and columns in the form of a matrix into which the respective tine parts (20a₂ ... 20f₂) of the contacts (20f..20f) in the form of a matrix are inserted and which is arranged to align the tine parts (20a₂ ... 20f₂) with through-holes (40a ... 40f) formed in a circuit board (40), wherein a recessed part (33) is formed in the undersurface of the tine plate (30) and encompasses a region containing some through-holes (30a, 30b) among the through-holes (30a ... 301) in the form of a matrix, **characterized in that**
said some through-holes (30a, 30b) in the recessed part (33) comprise a plurality of through-holes (30a, 30b) arranged in a direction substantially parallel to the housing (10) and in two rows adjacent to the housing (10).

2. The electrical connector according to claim 1, including a further recessed part (35) formed in the undersurface of the tine plate (30) and encompassing a region containing either one or a plurality of through-holes (32a ... 32d), the further recessed part (35) being present within a region that is 20% of the length of the tine plate (30) in the direction substantially parallel to the housing (10) from an end of the tine plate (30) in the direction of length.

3. The electrical connector according to claim 1, including a second recessed part (34) formed in the undersurface of the tine plate (30) and encompassing a region containing either one or a plurality of through-holes (31a ... 31d) in three columns adjacent to an end of the tine plate (30) in the direction of length substantially parallel to the housing (10).

4. The electrical connector according to claim 3, including a third recessed part (35) formed in the undersurface of the tine plate (30) and encompassing a region containing either one or a plurality of through-holes (32a ... 32d), the third recessed part (35) being present within a region that is 20% of the length of the tine plate (30) in the direction substantially parallel to the housing (10) from an end of the tine plate (30) in the direction of length.

5. The electrical connector according to claim 4, wherein the second and third recessed parts (34, 35) are present in opposite end portions of the tine plate (30) in the direction substantially parallel to the housing (10).

## Patentansprüche

1. Elektrischer Verbinder (1), der aufweist: ein Gehäuse (10); Kontakte (20a...20f) in der Form einer Matrix, die am Gehäuse (10) gesichert sind, und die jeweils Zinkenteile (20a₂...20f₂) aufweisen, die sich in Richtung der Außenseite des Gehäuses (10) erstrecken und danach nach unten gebogen sind; und eine Zinkenplatte (30), die sich in einer Richtung im Wesentlichen parallel zum Gehäuse (10) erstreckt, und die Durchgangslöcher (30a...30f) aufweist, die in einer Vielzahl von Reihen und senkrechten Reihen in der Form einer Matrix ausgebildet sind, in die die jeweiligen Zinkenteile (20a₂...20f₂) der Kontakte (20a...20f) in der Form einer Matrix eingesetzt werden und die angeordnet sind, um die Zinkenteile (20a₂...20f₂) mit den in einer Leiterplatte (40) ausgebildeten Durchgangslöchern (40a...40f) auszurichten, wobei ein ausgesparter Teil (33) in der Unterfläche der Zinkenplatte (30) ausgebildet ist und einen Bereich einschließt, der einige Durchgangslöcher (30a, 30b) unter den Durchgangslöchern (30a...30f) in der Form einer Matrix enthält, **dadurch gekennzeichnet, dass**
einige Durchgangslöcher (30a, 30b) im ausgesparten Teil (33) eine Vielzahl von Durchgangslöchern (30a, 30b) aufweisen, die in einer Richtung im Wesentlichen parallel zum Gehäuse (10) und in zwei Reihen benachbart dem Gehäuse (10) angeordnet sind.

2. Elektrischer Verbinder nach Anspruch 1, der einen weiteren ausgesparten Teil (35) umfasst, der in der Unterfläche der Zinkenplatte (30) ausgebildet ist und einen Bereich einschließt, der entweder ein oder eine Vielzahl von Durchgangslöchern (32a...32d) enthält, wobei der weitere ausgesparte Teil (35) innerhalb eines Bereiches vorhanden ist, der 20 % der Länge der Zinkenplatte (30) in der Richtung im Wesentlichen parallel zum Gehäuse (10) von einem Ende der Zinkenplatte (30) in der Richtung der Länge beträgt.

3. Elektrischer Verbinder nach Anspruch 1, der einen zweiten ausgesparten Teil (34) umfasst, der in der Unterfläche der Zinkenplatte (30) ausgebildet ist und einen Bereich einschließt, der entweder ein oder eine Vielzahl von Durchgangslöchern (31 a...31 d) in drei senkrechten Reihen benachbart einem Ende der Zinkenplatte (30) in der Richtung der Länge im Wesentlichen parallel zum Gehäuse (10) enthält.

4. Elektrischer Verbinder nach Anspruch 3, der einen dritten ausgesparten Teil (35) umfasst, der in der Unterfläche der Zinkenplatte (30) ausgebildet ist und einen Bereich einschließt, der entweder ein oder eine Vielzahl von Durchgangslöchern (32a...32d) enthält, wobei der dritte ausgesparte Teil (35) innerhalb eines Bereiches vorhanden ist, der 20 % der Länge der Zinkenplatte (30) in der Richtung im Wesentlichen parallel zum Gehäuse (10) von einem Ende der Zinkenplatte (30) in der Richtung der Länge beträgt.

5. Elektrischer Verbinder nach Anspruch 4, bei dem der zweite und dritte ausgesparte Teil (34, 35) in entgegengesetzten Endabschnitten der Zinkenplatte (30) in der Richtung im Wesentlichen parallel zum Gehäuse (10) vorhanden sind.

## Revendications

1. Connecteur électrique (1), comprenant un boîtier (10), des contacts (20a...20f) sous forme d'une matrice, fixés sur le boîtier (10) et comportant respectivement des parties de fourche (20a₂...20f₂) s'étendant vers l'extérieur du boîtier (10) et fléchies vers le bas, et une plaque à fourche (30), s'étendant dans une direction pratiquement parallèle au boîtier (10), et comportant des trous de passage (30a...30f), formés dans plusieurs rangées et colonnes sous forme d'une matrice, dans laquelle sont insérées les parties à fourche respectives (20a₂...20f₂) des contacts (20a...20f) sous forme d'une matrice, et agencée de sorte à aligner les parties de fourche (20a₂... 20f₂) avec des trous de passage (40a...40f) formés dans une plaque de circuit imprimé (40), une partie évidée (33) étant formée dans la surface inférieure de la plaque à fourche (30), entourant une région contenant certains trous de passage (30a, 30b) parmi les trous de passage (30a...30f) sous forme d'une matrice, **caractérisé en ce que**
lesdits certains trous de passage (30a, 30b) dans la partie évidée (33) comprennent plusieurs trous de passage (30a, 30b) agencés dans une direction pratiquement parallèle au boîtier (10) et en deux rangées adjacentes au boîtier (10).

2. Connecteur électrique selon la revendication 1, englobant une partie évidée additionnelle (35), formée dans la surface inférieure de la plaque à fourche (30) et entourant une région contenant un ou plusieurs des trous de passage (32a...32d), la partie évidée additionnelle (35) étant présente dans une région représentant 20% de la longueur de la plaque à fourche (30), dans la direction pratiquement parallèle au boîtier (10), à partir d'une extrémité de la plaque à fourche (30), dans la direction de la longueur.

3. Connecteur électrique selon la revendication 1, englobant une deuxième partie évidée (34), formée dans la surface inférieure de la plaque à fourche (30) et entourant une région contenant un ou plusieurs des trous de passage (31a...31d), dans trois colonnes adjacentes à une extrémité de la plaque à fourche (30), dans la direction de la longueur pratiquement parallèle au boîtier (10).

4. Connecteur électrique selon la revendication 3, englobant une troisième partie évidée (35), formée dans la surface inférieure de la plaque à fourche (30) et entourant une région contenant un ou plusieurs des trous de passage (32a...32d), la troisième partie évidée (35) étant présente dans une région représentant 20% de la longueur de la plaque à fourche (30), dans la direction pratiquement parallèle au boitier (10), à partir d'une extrémité de la plaque à fourche (30), dans la direction de la longueur.

5. Connecter selon la revendication 4, dans lequel les deuxième et troisième parties évidées (34, 35) sont présentes dans des parties d'extrémité opposées de la plaque à fourche (30), dans la direction pratiquement parallèle au boîtier (10).
